(19) Europäisches Patentamt / European Patent Office / Office européen des brevets

(11) **EP 2 879 293 A1**

(12) **EUROPEAN PATENT APPLICATION**

(43) Date of publication:
03.06.2015 Bulletin 2015/23

(51) Int Cl.:
*H03F 1/30* *(2006.01)*  *H03F 3/193* *(2006.01)*
*H03F 3/24* *(2006.01)*  *H03F 1/32* *(2006.01)*

(21) Application number: 13306639.9

(22) Date of filing: 29.11.2013

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: **ALCATEL LUCENT**
**92100 Boulogne-Billancourt (FR)**

(72) Inventor: **Cabezas-Lopez, Meritxell**
**70435 Stuttgart (DE)**

(74) Representative: **2SPL Patentanwälte PartG mbB**
**Postfach 15 17 23**
**80050 München (DE)**

Remarks:
Amended claims in accordance with Rule 137(2) EPC.

(54) **Apparatuses and methods for reducing electro-thermal memory effects for power amplifiers**

(57) Embodiments relate to a concept for preheating a power amplifier (104; 304) before a transmission of a transmit signal (106; 306) using the power amplifier (104; 304) in order to approach or reach a thermal steady state of the power amplifier prior to the transmission of the transmit signal.

Fig. 1

## Description

Embodiments of the present invention relate to power amplifiers, and, more particularly, to apparatuses and methods for reducing electro-thermal memory effects for power amplifiers.

Background

This section introduces aspects that may be helpful in facilitating a better understanding of the inventions. Accordingly, the statements of this section are to be read in this light and are not to be understood as admissions about what is in the prior art or what is not in the prior art.

In wireless and broadband applications, with the increase of bandwidth and power of modulated signals, the impact of memory effects of Power Amplifiers (PAs), in particular Radio Frequency PAs (RF-PAs), becomes more and more significant, particularly in systems using pre-distortion, where performance is very sensitive to such memory effects.

Memory effects for RF-PAs may be divided into two kinds: electrical memory effects and electro-thermal memory effects. Electrical memory effects may be reduced by appropriate design of matching and bias networks, for example. Electro-thermal memory effects lead to gain variations caused by a transistor's temperature-dependent electric parameters. As instantaneous dissipated power of a transistor varies with time, junction temperature the transistor changes also over time. Consequently, parameters of the temperature-sensitive transistor and the electro-thermal memory effect modulated by temperature may deteriorate the performance of the RF-PA with respect to nonlinearity. For example, already small changes in the gain of a power amplifier may translate into large Error Vector Magnitude (EVM).

Summary

Some simplifications may be made in the following summary, which is intended to highlight and introduce some aspects of the various exemplary embodiments, but such simplifications are not intended to limit the scope of the inventions. Detailed descriptions of a preferred exemplary embodiment adequate to allow those of ordinary skill in the art to make and use the inventive concepts will follow in later sections.

Some embodiments propose to compensate or minimize electro-thermal memory effects of a power amplifier by preheating said power amplifier. Electrical memory effects can be minimized by careful design of matching and/or biasing circuits.

According to a first aspect embodiments provide a transmitter apparatus. The transmitter apparatus comprises a preheating module configured to preheat a power amplifier before transmitting a transmit signal using the power amplifier.

In some embodiments the preheating module may be configured to preheat the power amplifier in order to reach or at least approach a thermal steady state of the power amplifier before transmitting the transmit signal.

In one or more embodiments the preheating module may be configured to preheat the power amplifier by self-heating. For that purpose the preheating module may be configured to use the power amplifier for amplifying a predefined preheating signal prior to transmitting the actual transmit signal.

According to a further aspect embodiments provide a method for a transmitter. The method comprises an act of preheating a power amplifier before transmitting, using the power amplifier, a transmit signal.

Some embodiments comprise digital circuitry installed within the transmitter apparatus for performing the respective method. Such a digital control circuitry, e.g., a Digital Signal Processor (DSP), a Field-Programmable Gate Array (FPGA), an Application-Specific Integrated Circuit (ASIC), or a general purpose processor, needs to be programmed accordingly. Hence, yet further embodiments also provide a computer program having a program code for performing embodiments of the method or at least one or more steps thereof, when the computer program is executed on a computer or a programmable hardware device.

Embodiments may contribute to cost reduction and may improve transceiver products in terms of stability and reliability. Besides embodiments may ensure a faster PA stabilization as its dynamic effects may be removed or at least reduced. Embodiments may provide several dB higher suppression of spectral regrowth when compared with conventional PA linearization techniques.

Brief description of the Figures

Some embodiments of apparatuses and/or methods will be described in the following by way of example only, and with reference to the accompanying figures, in which

Fig. 1 shows a block diagram of a transmitter apparatus according to an embodiment;

Fig. 2 shows a flow chart of a method according to an embodiment; and

Fig. 3 shows a block diagram of a transceiver apparatus according to an embodiment.

Description of Embodiments

Various example embodiments will now be described more fully with reference to the accompanying drawings in which some example embodiments are illustrated. In the figures, the thicknesses of lines, layers and/or regions may be exaggerated for clarity. Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

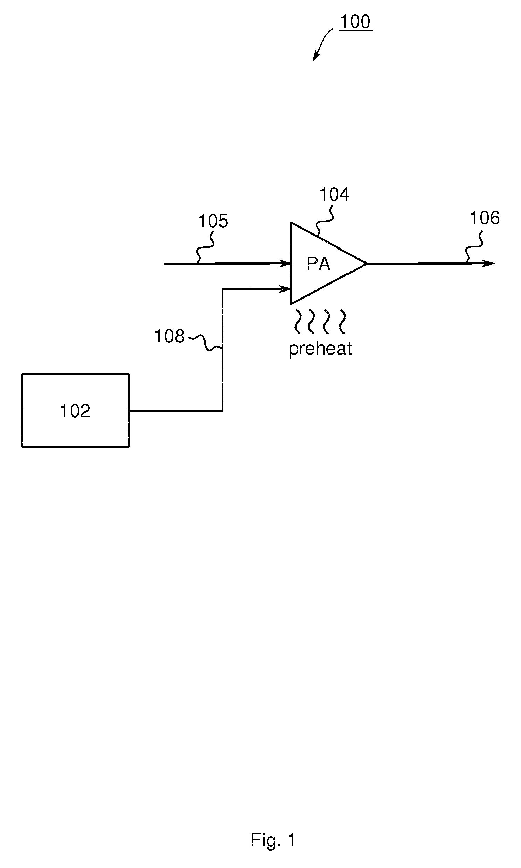

**Fig. 1** illustrates a schematic block diagram of a transmitter apparatus 100 according to an embodiment. The transmitter apparatus 100 includes a preheating module 102 which is configured to preheat a power amplifier (PA) 104 before transmitting a transmit signal 106 using the power amplifier 104.

In some embodiments the transmitter apparatus 100 may be part of or coupled to a base station or a mobile terminal of a wireless communication system, such as Long-Term Evolution (LTE), for example. A base station may also be referred to as NodeB or eNodeB according to 3rd Generation Partnership Project (3GPP) terminology. A mobile terminal may also be referred to as User Equipment (UE). Although not limited thereto, embodiments may be particularly useful for wireless Time Division Duplex (TDD) systems, such as LTE TDD. In wireless TDD systems transmissions travel in both directions, uplink and downlink, on the same frequency band and separated in time. That is to say, time may be subdivided into downlink transmission time intervals, such as downlink slots, subframes, or frames, as well as uplink transmission time intervals, such as uplink slots, subframes, or frames.

In embodiments the preheating module 102 may be configured to preheat the PA 104 in a preheat time interval between a first and a second transmission time interval, wherein the transmit signal is transmitted in or during the second transmission time interval. For TDD systems, for example, and when the transmitter apparatus 100 is part of a base station, the preheat time interval may be during or in an uplink transmission time interval in between two consecutive downlink transmission time intervals. If the transmitter apparatus 100 is part of a UE, the preheat time interval may also be during a downlink transmission time interval in between two consecutive uplink transmission time intervals.

The PA 104 may be a Radio Frequency PA (RF-PA) for amplifying signals in the RF domain. Thereby the RF domain denotes a frequency range from several MHz to several GHz. For LTE TDD, for example, frequencies in the range of 2 GHz to 4 GHz are commonly used today. The PA 104 may be used to convert a low-power RF signal 105 into a larger RF signal 106 of significant power, typically for driving an antenna (not shown) of the transmitter apparatus 100.

The PA 104 may include one or more transistors. For example, adequate transistors for RF PAs include Field Effect Transistors (FETs), such as high power RF Laterally Diffused Metal Oxide Semiconductor (LDMOS) transistors. During operation the PA's 104 temperature may change significantly due to flow of electrical currents. An electro-thermal model of a transistor may describe self-heating effects produced by junction temperature of the transistor varying with its instantaneous dissipated power. A simple thermal model for a device, such as a transistor, may include a thermal resistance $R_{th}$ (°C/W) and a thermal capacitance $C_{th}$, (J/°C), for example. Similar to an electric time constant a thermal time constant $\tau_{th}$ may then be expressed by $R_{th}$ and $C_{th}$, for example, $\tau_{th} = R_{th} * C_{th}$. Hence, the thermal time constant $\tau_{th}$ may be regarded as the time required for a device to change 63.2% (1/e) of the total difference between its initial and final body temperature when subjected to a step function change in temperature, under zero power conditions.

The PA's 104 temperature, e.g. the junction temperature of the one or more transistors, may change significantly during operation. Electro-thermal memory effects caused by the temperature variations of the PA 104 may negatively affect its distortion generation. The electro-thermal memory effects take place in a transient state. For instance when the PA 104 does not process or amplify any signal, it may cool-down very fast and when a new transmission arrives it takes $\tau_{th}$ until the PA 104 achieves its steady-state temperature again. In the steady-state the electro-thermal memory effects may be negligent. However, they may not be neglected in the transient state. Therefore the module 102 may be configured to thermally stabilize the PA 104 by preheating the PA 104 before the transmission of the transmit signal 106 starts. When the transmission of the actual transmit signal 106 starts the PA 104 will then already substantially be in its thermal steady state. This may reduce undesired non-linearity effects of the PA 104 due to electro-thermal memory effects.

Hence, in embodiments the preheating module 102 is configured to act on the PA 104 in order to bring it to or at least close to its thermal steady state. While in some embodiments the preheating may be performed by an external preheating device separate from the PA 104, such as a separate heater, other embodiments propose preheating the PA 104 by means of self-heating. Hence, the preheating module 102 may be configured to preheat the PA 104 before transmitting the transmit signal 106 by causing self-heating of the PA 104. As a result of the preheating the PA 104 will substantially be in thermal steady state when the transmission of the transmit signal 106 starts. In thermal steady state the PA's gain curve has substantially no fluctuations (constant level) over time. Hence, in thermal steady state achieved by preheating the PA 104 may be regarded as a pure memoryless PA.

The preheating may take place shortly before the transmission of the transmit signal 106 starts. Thereby the preheating time or period may be dependent on the thermal time constant $\tau_{th}$ of the PA 104, for example. In particular, the preheating time may be substantially equal to the PA's thermal time constant $\tau_{th}$. In such embodiments the preheating module 102 may be configured to determine the thermal time constant $\tau_{th}$ of the PA 104 prior to preheating the PA 104. This may be done by looking up the thermal time constant $\tau_{th}$ obtained from the PA's datasheet in an optional memory device of the transmitter apparatus 100, for example. For another example, the thermal time constant $\tau_{th}$ may be determined by one or more measurements.

In some embodiments the preheating module 102 may be configured to determine the thermal time constant $\tau_{th}$ based on a pulsed excitation of the PA 104. When performing pulsed excitation adequate signal pulses may be applied to the PA 104 in order to raise the PA's 104 body temperature well above that of the ambient. A pulse may be designed such that power is maintained until thermal stabilization of the PA 104 at the elevated temperature is achieved. Then the pulse is removed from the PA 104 and, simultaneously, a timer may be triggered. The thermal resistance of the PA 104 may be continuously monitored and when it indicates that the PA 104 has cooled to the temperature which represents 63.2% of the temperature difference between the elevated temperature and that of the ambient temperature, the timer may be stopped. The time indicated represents the thermal time constant $\tau_{th}$ and may usually be expressed in "seconds". For such measurements the apparatus 100 may optionally also comprise one or more temperature sensors for sensing the PA's temperature.

In some embodiments the preheating may start substantially $\tau_{th}$ seconds before the start of the actual transmission of the transmit signal 106, which may be a downlink signal in a downlink transmission time interval (e.g. downlink frame), for example. In cases of self-heating, the preheating module 102 may be configured to cause the PA 104 to amplify a predefined preheating signal 108 prior to the transmission of the transmit signal 106. The predefined preheating signal may be a low-power RF signal and may comprise one or more known training symbols. A number of training symbols of the predefined preheating signal 108 may be determined based on the thermal time constant $\tau_{th}$. For example, the number of training symbols may for example be

$$n_{symbols} = \left\lceil \frac{\tau}{T_{symbol}} \right\rceil$$

(with $\lceil \rceil$ being the ceil operator), if the PA's thermal time constant $\tau_{th}$ is larger than a symbol duration $T_{symbol}$ of a training symbol. A value

of $n_{symbols} = \left\lfloor \frac{\tau}{T_{symbol}} \right\rfloor$ (with $\lfloor \rfloor$ being the floor operator) may also be possible. On the other hand, the number of training symbols may be one, if the thermal time constant $\tau_{th}$ is smaller than or equal to the symbol duration $T_{symbol}$. Note that also other methods for determining the number of training symbols are conceivable. A preferable outcome may be that the preheating starts $(1 \pm 0.2)\tau_{th}$ before the start of the next transmission time interval for transmit signal 106.

If embodiments are applied to wireless communication systems, such as LTE TDD, the predefined preheating signal 108 may be derived from standardized downlink or uplink test signals. In case of LTE the predefined preheating signal may be derived from the Evolved UMTS Terrestrial Radio Access (E-UTRA) Test Models (TM), for example E-TM1.1 or E-TM1.2. These are downlink, single-antenna port signals. However, other training signals are also possible.

The amplification of the predefined preheating signal 108 by means of the PA 104 may take place at the highest amplification level or power level defined for transmitting the transmit signal 106. The preheating module 102 may hence be configured to amplify the predefined preheating signal to the highest power level defined for transmitting the transmit signal 106. This may enable to quickly reach the PA's 104 thermal steady state. Thereby the highest power level may vary from system to system.

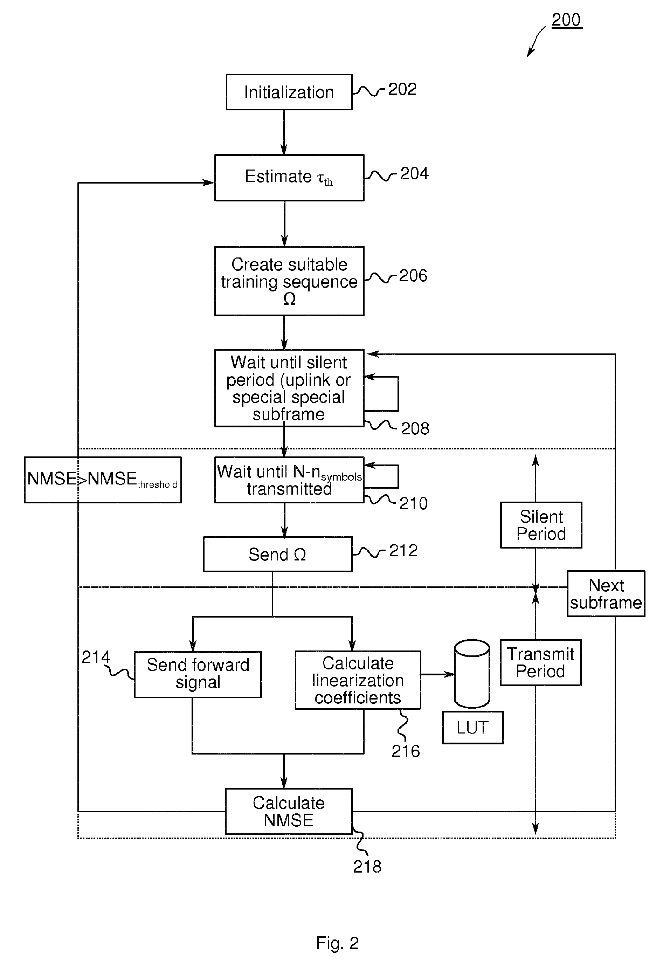

Turning now to **Fig. 2,** an embodiment of a method 200 for the transmitter apparatus 100 will be described.

The method 200 is directed to improving linearization scheme performance in "silent" periods, for instance, time slots with no user traffic or uplink slots in LTE TDD systems. The linearization scheme performance is limited by the PA's 104 dynamic effects. Conventionally, in order to thermally stabilize the PA 104, a heat sink may be placed close to the device. Such solutions, however, do not avoid the dynamic effects at all, but may reduce its dynamic range. Another conventional solution would be to replace the PA 104 by a one with lower dynamic effects (usually an expensive one).

After an initialization act 202, the method 200 comprises an act 204 of estimating the PA's 104 thermal time constant $\tau_{th}$. This may be done as has been described above. For example, estimating the thermal time constant $\tau_{th}$ may be triggered if non-linear effects of the PA 104 exceed a predefined threshold. A metric could be the so-called Normalized Mean Square Error (NMSE) between a forward signal travelling through the PA 104 and a feedback signal fed back from the PA's output. If the measured NMSE is larger than a $NMSE_{threshold}$ (for example, -20dB) than estimating 204 the thermal time constant $\tau_{th}$ may be triggered. In some embodiments the forward signal and the feedback signal could be compared in the digital baseband domain, as will be described further below.

Further, the method 200 comprises an act 206 of determining a suitable training sequence $\Omega$ for a preheating signal, the training sequence comprising $n_{symbols}$ training symbols. For example, the training sequence $\Omega$ may be derived from E-UTRA Test Models, such as E-TM1.1 or E-TM1.2. Preheating of the PA 104 takes place in "silent" periods, which are periods where the transmitter apparatus 100 usually does not send any downlink signals intended for associated UE's, for example. Similarly, silent periods are also available for the uplink in other embodiment. In act 208 the transmitter apparatus 100 waits for such a silent period, which may be an uplink frame or subframe, for example. As an example it may be assumed that a subframe comprises $N$ symbols, i.e., the $N$ = number of symbols per subframe. Starting from the beginning of the silent period (e.g. uplink subframe) the transmitter apparatus 100 or the module 102 may wait a time corresponding to ($N$ - $n_{symbols}$) symbols (see act 210) until the preheating signal 108 comprising the training sequence $\Omega$ is passed through the PA 104 (see act 212) in order to cause self-heating up to its thermal steady state. Note that the amplified preheating signal may be decoupled from an antenna in order not to cause interference on uplink signals, for example. Sending the preheating signal 108 lasts $n_{symbols}$ symbols and is hence finished when the next "non-silent" transmit period starts, for example, a next downlink subframe. During the transmit period the transmitter apparatus 100 may transmit a downlink signal 106 to associated UEs (see act 214). In order to compensate for power amplifier non-linearities the transmit apparatus 100 may predistort the downlink signal by calculating and applying linearization coefficients to the downlink signal prior to passing it through the PA 104. A difference between the amplified downlink signal 106 and the non-amplified downlink signal may be determined by means of feeding back the amplified downlink signal and calculating the NMSE between the forward signal and the feedback signal.

With the method 200 it may be ensured that the PA 104 has reached its thermal steady state before the actual slot (downlink or transmit signal 106) is sent.

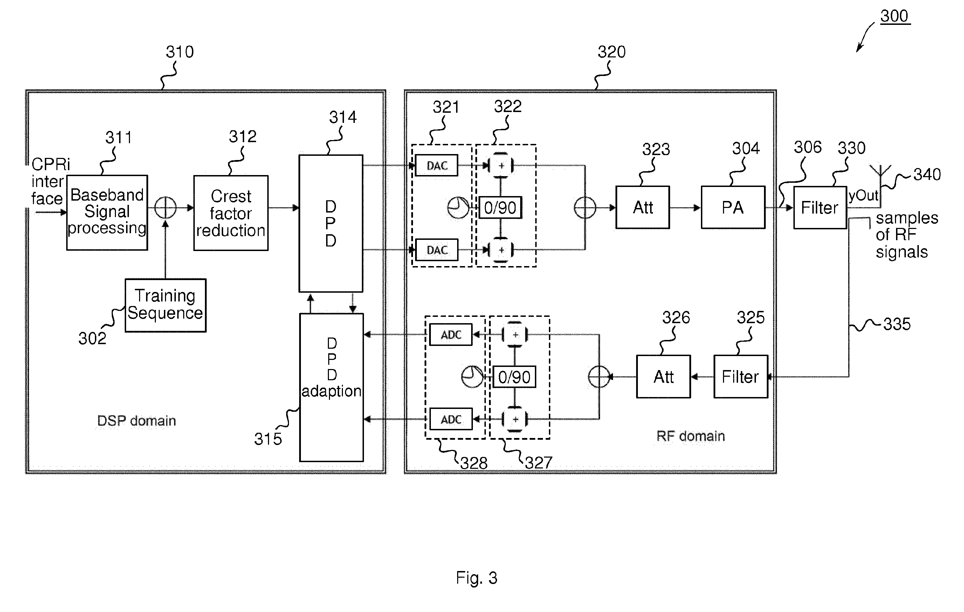

The method 200 may be implemented by an embodiment of a transceiver apparatus 300 which is schematically illustrated in **Fig. 3.** The transceiver apparatus 300, which may be implemented in a Remote Radio Head (RRH), for example, comprises a digital baseband module 310 coupled to a RF module 320. An RF transmit signal 306 output from the RF module 320 is bandpass filtered by a bandpass filter 330 and then fed to an antenna 340 for transmission over a wireless medium.

A baseband signal processing module 311 receives digital baseband samples via a Common Public Radio Interface (CPRI) to perform digital signal processing methods on the received signal samples. The digital baseband samples may be transmitted to a receiver during subsequent intermittent transmission time intervals, such as downlink subframes, for example. There may be silent periods, such as uplink subframes, between two consecutive subsequent transmission time intervals. During such silent periods a training sequence module 302 may provide one or more known digital baseband training symbols $\Omega = \{S_0, S_1, ..., S_{nsymbols}\}$ for generating a preheating signal. Hence, the training sequence module 302 may also be interpreted as preheating module in this example.

Crest factor or peak-to-average ratio reduction may be performed on the digital baseband data provided by modules 311 and/or 302 by a crest factor reduction module 312 before the resulting peak-to-average ratio reduced digital baseband signal is digitally predistorted by Digital PreDistortion (DPD) module 314. Inphase (I) and Quadrature (Q) components of the digitally predistorted baseband signal are then digital to analog converted by Digital-to-Analog Converters (DACs) 321. The resulting analog baseband signal is then up-converted to the RF domain by an up-conversion circuit 322 to obtain a low-power RF signal. After passing an optional analog attenuator module 323 the low-power RF signal is amplified by RF-PA 104, filtered by bandpass filter 330 and then fed to antenna 340 for transmission. Thereby module 323 may be considered as an analog power control to condition the IQ samples to the RF-PA input characteristic.

A receive path of transceiver apparatus 300 comprises an RF bandpass filter 325, a Low Noise Amplifier (LNA) 326, a down-conversion circuit 327, and Analog-to-Digital Converters (ADCs) 328. The LNA 326 may amplify the received signal, which may be received with a rather low level. An RF feedback signal 335 may be converted back to the digital baseband domain and used to adjust the digital predistortion (see module 315) to a current nonlinear behavior of the PA 304.

In the example embodiment of Fig. 3, thermal memory effects of the RF PA 304 may be compensated / reduced by preheating the RF PA 304 via the training sequence $\Omega = \{S_0, S_1, ..., S_{nsymbols}\}$ provided by the training sequence module 302 during silent periods between transmission time intervals. The duration of the training sequence $\Omega$ may correspond at least to the thermal time constant $\tau_{th}$ of the RF PA 304, such that the RF PA 304 may achieve its steady-state temperature after amplifying the preheating signal. That is to say, thermal stabilization of the RF-PA 304 before a DL slot in a LTE-TDD system or before a high user traffic frame is to be sent may be achieved.

To summarize, a PA preheating concept according to an embodiment comprises:

- determining the thermal time constant $\tau_{th}$ of the PA;
- calculating a number $n_{symbols}$ of training symbols, each training symbol having a symbol duration $T_{symbol}$:

  if $\tau_{th} > T_{symbol}$

$$n_{symbols} = \left\lceil \frac{\tau}{T_{symbol}} \right\rceil$$

  else
  $n_{symbols} = 1$

- pick $n_{symbols}$ of the training sequence $\Omega = \{S_0, S_1, ..., S_{nsymbols}\}$ and amplify it with the highest available power level;
- send or amplify the training sequence $\Omega = \{S_0, S_1, ..., S_{nsymbols}\}$ before actual slot.

Embodiments may contribute to cost reduction and may improve transceiver products in terms of stability and reliability. Besides embodiments may ensure a faster PA stabilization as its dynamic effects may be removed or at least reduced. Embodiments may provide several dB higher suppression of spectral regrowth when compared with conventional PA linearization techniques.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks shall be understood as functional blocks comprising circuitry that is adapted for performing a certain function, respectively. Hence, a "module for s.th." may as well be understood as a "module being adapted or suited for s.th.". A module being adapted for performing a certain function does, hence, not imply that such module necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

**Claims**

1. A transmitter (100; 300) apparatus, comprising:

   a preheating module (102; 302) to preheat a power amplifier (104; 304) before transmitting a transmit signal (106; 306) using the power amplifier (104; 304).

2. The transmitter apparatus (100; 300) of claim 1, wherein the preheating module (102; 302) is configured to preheat the power amplifier (104; 304) in a preheat time interval between a first and a second transmission time interval, wherein the transmit signal is transmitted in the second transmission time interval.

3. The transmitter apparatus (100; 300) of claim 2, wherein the preheat time interval is during an uplink transmission time interval, and wherein the first and the second transmission time interval correspond to a first and a second downlink transmission time interval.

4. The transmitter apparatus (100; 300) of claim 1, wherein the preheating module (102; 302) is configured to preheat the power amplifier (104; 304) to approach a thermal steady state of the power amplifier (104; 304) before transmitting the transmit signal (106; 306).

5. The transmitter apparatus (100; 300) of claim 1, wherein the preheating module (102; 302) is configured to amplify, using the power amplifier (104; 304), a predefined preheating signal (108) prior to the transmission of the transmit signal (106; 306).

6. The transmitter apparatus (100; 300) of claim 5, wherein predefined preheating signal (108) comprises one or more training symbols.

7. The transmitter apparatus (100; 300) of claim 5, wherein the preheating module (102; 302) is configured to amplify the predefined preheating signal (108) to the highest power level defined for transmitting the transmit signal (106; 306).

8. The transmitter apparatus (100; 300) of claim 1, wherein the preheating module (102; 302) is configured to determine a thermal time constant of the power amplifier (104; 304) prior to preheating the power amplifier.

9. The transmitter apparatus (100; 300) of claim 8, wherein the preheating module (102; 302) is configured to determine a thermal time constant based on pulsed excitation of the power amplifier (104; 304).

10. The transmitter apparatus (100; 300) of claim 8, wherein the preheating module (102; 302) is configured to determine a number of training symbols of a predefined preheating signal (108) based on the thermal time constant.

11. The transmitter apparatus (100; 300) of claim 10, wherein the number of training symbols is

    $$n_{symbols} = \left\lceil \frac{\tau}{T_{symbol}} \right\rceil$$ if the thermal time constant $\tau$ is larger than a symbol duration $T_{symbol}$ of a training symbol, and wherein the number of training symbols is one if the thermal time constant $\tau$ is smaller than or equal to the symbol duration $T_{symbol}$.

12. The transmitter apparatus (100; 300) of claim 1, wherein the power amplifier (104; 304) is a radio frequency signal power amplifier.

13. The transmitter apparatus (100; 300) of claim 1, wherein the transmitter apparatus is part of a base station or a mobile terminal of a wireless communication system.

14. The transmitter apparatus (100; 300) of claim 13, wherein the wireless communication system is a Long Term Evolution Time Division Duplex system.

15. A method (200) for a transmitter (100; 300), the method comprising:

    preheating a power amplifier (104; 304) before transmitting, using the power amplifier (104; 304), a transmit signal (106; 306).

**Amended claims in accordance with Rule 137(2) EPC.**

1. A transmitter (100; 300) apparatus, comprising:

   a preheating module (102; 302) to preheat a power amplifier (104; 304) before transmitting a transmit signal (106; 306) using the power amplifier (104; 304),
   wherein the preheating module (102; 302) is configured to amplify, using the power amplifier (104; 304), a predefined preheating signal (108) comprising one or more training symbols prior to the transmission of the transmit signal (106; 306)
   wherein the preheating module (102; 302) is configured to determine a thermal time constant of the power amplifier (104; 304) prior to preheating the power amplifier; and
   wherein the preheating module (102; 302) is configured to determine a number of training symbols of the predefined preheating signal (108) based on the thermal time constant.

2. The transmitter apparatus (100; 300) of claim 1, wherein the preheating module (102; 302) is configured to preheat the power amplifier (104; 304) in a preheat time interval between a first and a second transmission time interval, wherein the transmit signal is transmitted in the second transmission time interval.

3. The transmitter apparatus (100; 300) of claim 2, wherein the preheat time interval is during an uplink transmission time interval, and wherein the first and the second transmission time interval correspond to a first and a second downlink transmission time interval.

4. The transmitter apparatus (100; 300) of claim 1, wherein the preheating module (102; 302) is configured to preheat the power amplifier (104; 304) to approach a thermal steady state of the power amplifier (104; 304) before transmitting the transmit signal (106; 306).

5. The transmitter apparatus (100; 300) of claim 1, wherein the preheating module (102; 302) is configured to amplify the predefined preheating signal (108) to the highest power level defined for transmitting the transmit signal (106; 306).

6. The transmitter apparatus (100; 300) of claim 1, wherein the preheating module (102; 302) is configured to determine a thermal time constant based on pulsed excitation of the power amplifier (104; 304).

7. The transmitter apparatus (100; 300) of claim 1, wherein the number of training symbols is

$$n_{symbols} = \left\lceil \frac{\tau}{T_{symbol}} \right\rceil$$ if the thermal time constant $\tau$ is larger than a symbol duration $T_{symbol}$ of a training symbol, and wherein the number of training symbols is one if the thermal time constant $\tau$ is smaller than or equal to the symbol duration $T_{symbol}$.

8. The transmitter apparatus (100; 300) of claim 1, wherein the power amplifier (104; 304) is a radio frequency signal power amplifier.

9. The transmitter apparatus (100; 300) of claim 1, wherein the transmitter apparatus is part of a base station or a mobile terminal of a wireless communication system.

10. The transmitter apparatus (100; 300) of claim 9, wherein the wireless communication system is a Long Term Evolution Time Division Duplex system.

11. A method (200) for a transmitter (100; 300), the method comprising:

    preheating a power amplifier (104; 304) before transmitting, using the power amplifier (104; 304), a transmit signal (106; 306), the method further comprising
    amplifying, using the power amplifier (104; 304), a predefined preheating signal (108) comprising one or more training symbols prior to the transmission of the transmit signal (106; 306)
    determining a thermal time constant of the power amplifier (104; 304) prior to pre-heating the power amplifier; and
    determining a number of training symbols of the predefined preheating signal (108) based on the thermal time constant.

100

105

104

106

PA

108

preheat

102

Fig. 1

_200_

Initialization ⌇ 202

Estimate $\tau_{th}$ ⌇ 204

Create suitable
training sequence
$\Omega$ ⌇ 206

Wait until silent
period (uplink or
special special
subframe ⌇ 208

NMSE>NMSE$_{threshold}$

Wait until N-n$_{symbols}$
transmitted ⌇ 210

Silent
Period

Send $\Omega$ ⌇ 212

Next
subframe

Send forward
signal

Calculate
linearization
coefficients

LUT

Transmit
Period

214

216

Calculate
NMSE

218

Fig. 2

Fig. 3

EP 2 879 293 A1

Europäisches Patentamt
European Patent Office
Office européen des brevets

## EUROPEAN SEARCH REPORT

Application Number

EP 13 30 6639

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 920 808 A (JONES DAVID E [US] ET AL) 6 July 1999 (1999-07-06) <br> * column 1, lines 6-10 * <br> * column 2, lines 3-62 * <br> * column 5, line 13 - column 6, line 2 * <br> * column 8, lines 34-59 * <br> * column 14, line 5 - column 16, line 16; figures 2,6,9 * | 1-15 | INV. <br> H03F1/30 <br> H03F3/193 <br> H03F3/24 <br> H03F1/32 |
| X | US 2011/128078 A1 (DOHERTY MARK [US] ET AL) 2 June 2011 (2011-06-02) <br> * paragraphs [0012] - [0046], [0060] - [0086]; figures 1-8 * | 1-15 | |
| X | US 6 104 917 A (KETONEN VELI-PEKKA [US]) 15 August 2000 (2000-08-15) <br> * column 1, lines 6-17 * <br> * column 2, line 65 - column 4, line 19 * <br> * column 5, lines 12-31 * <br> * column 6, line 34 - column 7, line 29; figures 2,5 * | 1-15 | |
| X | US 2012/286866 A1 (KHANIFAR AHMAD [US] ET AL) 15 November 2012 (2012-11-15) <br> * paragraphs [0013] - [0019], [0027] - [0052]; figures 1-5 * | 1-15 | TECHNICAL FIELDS SEARCHED (IPC) <br><br> H03F |
| X | US 6 054 894 A (WRIGHT ANDREW S [CA] ET AL) 25 April 2000 (2000-04-25) <br> * column 4, lines 1-18 * <br> * column 23, line 7 - column 24, line 38 * <br> * column 35, line 55 - column 36, line 61; figure 2 * | 1-15 | |
| A | US 4 317 083 A (BOYD WILLIAM M) 23 February 1982 (1982-02-23) <br> * column 3, line 38 - column 4, line 62; figure 4 * | 8-11 | |

The present search report has been drawn up for all claims

| Place of search | Date of completion of the search | Examiner |
|---|---|---|
| The Hague | 6 February 2014 | Goethals, Filip |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                EP 13 30 6639

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2014

| Patent document cited in search report | | Publication date | Patent family member(s) | | Publication date |
|---|---|---|---|---|---|
| US 5920808 | A | 06-07-1999 | NONE | | |
| US 2011128078 | A1 | 02-06-2011 | US 2011128078 A1 | | 02-06-2011 |
| | | | US 2013034144 A1 | | 07-02-2013 |
| US 6104917 | A | 15-08-2000 | AU 3389900 A | | 21-09-2000 |
| | | | US 6104917 A | | 15-08-2000 |
| | | | WO 0052786 A1 | | 08-09-2000 |
| US 2012286866 | A1 | 15-11-2012 | NONE | | |
| US 6054894 | A | 25-04-2000 | NONE | | |
| US 4317083 | A | 23-02-1982 | NONE | | |

EPO FORM P0459

For more details about this annex : see Official Journal of the European Patent Office, No. 12/82